Europäisches Patentamt

European Patent Office

Office européen des brevets

Veröffentlichungsnummer: **0 283 788**
A1

## EUROPÄISCHE PATENTANMELDUNG

Anmeldenummer: 88103311.2

Anmeldetag: 03.03.88

Int. Cl.4 **H01L 29/36** , H01L 29/74 , H01L 29/10

Priorität: 09.03.87 DE 3707506

Veröffentlichungstag der Anmeldung:
28.09.88 Patentblatt 88/39

Benannte Vertragsstaaten:
CH DE FR GB IT LI SE

Anmelder: **Siemens Aktiengesellschaft Berlin und München**
**Wittelsbacherplatz 2**
**D-8000 München 2(DE)**

Erfinder: **Bechteler, Martin, Dr.**
**Nelkenweg 10**
**D-8011 Kirchheim(DE)**
Erfinder: **Gross, Wolfgang, Dr.**
**Münchner Strasse 111a**
**D-8043 Unterföhring(DE)**

Abschaltbares Leistungshalbleiterbauelement.

Abschaltbare Leistungshalbleiterbauelemente weisen einen im Abschaltfall sperrenden pn-Übergang auf, dessen eine am pn-Übergang liegende Zone einen hohen Dotierungsgradienten aufweist. Dies bedingt aber eine geringe dynamische Spannungsfestigkeit des Leistungshalbleiterbauelements. Um die dynamische Spannungsfestigkeit des Leistungshalbleiterbauelementes zu erhöhen, wird vorgeschlagen die eine Zone mindestens in einen von pn-Übergang ausgesehenen 20 qm breiten Bereich mit einem maximalen Dotierungsgradienten $dN_2/dx = 5 \times 10^{16} cm^{-4}$ und einer bestimmten Grunddotierstoffkonzentration zu versehen.

FIG 3

EP 0 283 788 A1

## Abschaltbares Leistungshalbleiterbauelement

Die Erfindung betrifft ein abschaltbares Leistungshalbleiterbauelement mit einem Halbleiterkörper, der mindestens zwei aneinandergrenzende Zonen entgegengesetzten Leitfähigkeitstyps aufweist, welche im Abschaltfall einen sperrenden pn-Übergang bilden, und dessen eine Zone eine konstante Dotierstoffkonzentration ($N_1$) aufweist.

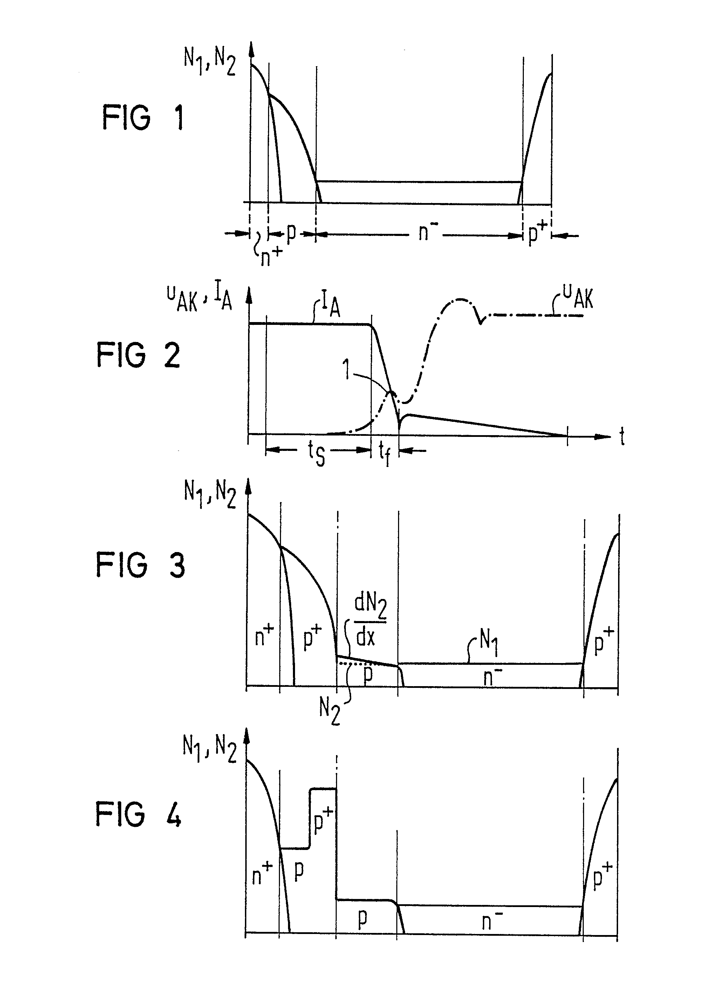

Ein solches abschaltbare Leistungshalbleiterbauelement ist z.B. in IEEE, Transactions on Electronic Devices, Vol. ED-32, No 9, 1985, S. 1830 ff. beschrieben. Dort ist in Figur 1 ein typisches Dotierungsprofil eines GTO-Thyristors dargestellt. Dieser GTO-Thyristor hat eine breite und konstant - schwach n-dotierte Basiszone, an dessen eine Seite eine schmale und mit einem sehr hohen Dotierungsgradienten versehene p-dotierte Emitterzone grenzt. An die andere Seite der schwach n-dotierten Basiszone schließt sich eine, einen ebenfalls sehr hohen Dotierungsgradienten aufweisende - schmale p-dotierte Basiszone an, die mit einer Gateelektrode verbunden ist. An diese stark p-dotierte Basiszone grenzt eine noch höher n-dotierte Emitterzone an. Der prinzipielle Verlauf des Dotierungsprofiles eines solchen GTO-Thyristors ist in der Figur 2 der vorliegenden Anmeldung wiedergegeben.

Es ist weiterhin bekannt, z.B. aus "Der Elektroniker", Nr. 11, 1985, S. 44 ff., dem GTO-Thyristor einen sogenannten Beschaltungskondensator parallel zu schalten. Dieser Beschaltungskondensator hat die Aufgabe, die positive Spannungssteilheit beim Abschalten des GTO-Thyristors zu begrenzen. Diesem Beschaltungskondensator ist häufig zusätzlich eine Diode mit parallelgeschaltetem Widerstand in Reihe geschaltet und unter dem Begriff "RCD-Beschaltung" oder "Snubber-Circuit" bekannt.

Durch Anlegen eines negativen Steuerimpulses an den Gate-Anschluß des bekannten GTO-Thyristors, kann der GTO-Thyristor gelöscht, also abgeschaltet werden. Beim Abschaltvorgang werden nach dem Ablauf der Speicherphase vom n-Emitter keine Elektronen mehr geliefert, so daß im Halbleiterkörper ein reiner Löcherstrom von der n-Basiszone über die p-Basiszone zur Gate-Elektrode gelangt. Die Raumladung dieser Defektelektronen, die sich in etwa mit Sättigungsgeschwindigkeit ($v_s = 10^7$ cm/sec in Silicium) bewegen, addiert sich zu der Raumladung, die durch die Dotierung des Halbleiterkörpers gegeben ist. Dadurch ergibt sich eine Verschiebung der Feldspitze vom dotierten pn-Übergang in die p-Basiszone hinein, und zwar bis zu dem Punkt, an dem die Dotierstoffkonzentration $N_A$ der p-Basiszone genau der Löcherdichte entspricht. Außerdem ergibt sich durch die Veränderung der Raumladung ein Zusammendrängen der Raumladungszone in der n-Basiszone bzw. eine Aufweitung der Raumladungszone in der p-Basiszone.

Bei den bekannten Dotierungsprofilen der p-Basiszone mit hohem Dotierungsgradienten und den in der Praxis hohen auftretenden Stromdichten (z.B. 100 A/cm²) ist dieser hohe Dotierungsgradient so hoch, daß die Aufweitung der Raumladungszone in der p-Basiszone das Zusammendrängen der Raumladungszone in der n-Basiszone nicht ausgleichen kann. Damit ist aber die Spannungsfestigkeit reduziert. Da der Strom in der Fallzeit beim Abschalten des GTO-Thyristors mit bis zu mehreren 1000 A/µsec in die RCD-Beschaltung kommutiert, entstehen bei noch hohem Stromfluß durch den Halbleiterkörper hohe, durch die parasitären RCD-Induktivitäten bedingte Spannungsspitzen. Dies kann wegen der geringen dynamischen Spannungsfestigkeit zur Zerstörung des GTO-Thyristors führen.

Das gleiche Problem tritt prinzipiell bei allen Bauelementen mit einem pn-Übergang auf, der beim Stromkommutieren schnell ausgeräumt werden soll, so z.B. bei Dioden oder bei bipolaren Transistoren, die durch Inversion der Basisansteuerung abgeschaltet werden.

Der Erfindung liegt die Aufgabe zugrunde, bei abschaltbaren Leistungshalbleiterbauelementen die dynamische Spannungsfestigkeit zu erhöhen.

Diese Aufgabe wird dadurch gelöst, daß die andere Zone einen an den pn-Übergang anschließenden mindestens 20 µm (20 µm = $20.10^{-6}$m) breiten Bereich aufweist, daß dieser Bereich eine Grunddotierstoffkonzentration $N_2 = j/(e \cdot v)$ mit j = maximale Stromdichte im Abschaltfall bei homogen angenommener Verteilung, e = Elementarladung und $v = 10^7$ cm/sec, aufweist, und daß in diesem Bereich ein vom pn-Übergang aus gesehen maximaler Dotierungsgradient $dN_2/dx = 5 \cdot 10^{16}$ cm$^{-4}$ nicht überschritten ist.

Durch das abschaltbare Leistungshalbleiterbauelement gemäß der Erfindung wird erreicht, daß Abschaltfall die Raumladung der durch den Halbleiterkörper fließenden Ladungsträger nahe dem pn-Übergang durch die ortsfeste Raumladung der Dotierung kompensiert wird und dadurch eine ausgedehnte Zone hoher Feldstärke entsteht und somit eine hohe dynamische Spannungsfestigkeit gewährleistet ist.

Weiterbildungen der Erfindung sind Gegenstand der Unteransprüche.

Die Erfindung wird im folgenden anhand der Figuren 2 bis 4 näher erläutert. Als Beispiel für ein Leistungshalbleiterbauelement wird dabei ein GTO-Thyristor, der gemäß der Erfindung ausgebildet ist, beschrieben. Der GTO-Thyristor weist dabei $n^+pn^-p^+$-Struktur auf, dessen P-Basiszone mit einer Gateelektrode verbunden ist. Es zeigen:

FIG 2 einen typischen Anodenstrom-und Anoden-Kathoden-Spannungsverlauf während der Abschaltphase eines GTO-Thyristors mit RCD-Beschaltung und induktiver Last,

FIG 3 erstes Beispiel für ein Dotierungsprofil eines GTO-Thyristors gemäß der Erfindung, und

FIG 4 ein zweites Beispiel für ein Dotierungsprofil eines GTO-Thyristors gemäß der Erfindung.

Das prinzipielle Abschaltverhalten eines GTO-Tyristors mit RCD-Beschaltung und induktiver Last ist am Verlauf des in FIG 2 dargestellten Anodenstroms $I_A$ und am Anoden-Kathoden-Spannungsverlauf $U_{AK}$, der strichliert gezeichnet ist, zu erkennen. Nach Anlegen einer für das Abschalten des stromführenden GTO-Tyristors nötigen Rückwärtssteuerspannung an dessen Gate-Kathoden-Strecke baut sich ein Rückwärtssteuerstrom auf. Bis zu dem Zeitpunkt, an dem der Rückwärtssteuerstrom genügend groß ist, ändert sich der Anodenstromverlauf $I_{AK}$ nicht. Dies ist die sogenannte Speicherphase $t_S$ im Abschaltfall. Ist der Rückwärtssteuerstrom genügend groß, so setzt ein steiler Abfall des Anodenstromes $I_A$ mit bis zu mehreren 1000 A/µsec ein. Dies ist in FIG 2 als Fallphase $t_f$ bezeichnet. Aufgrund der Induktivitäten der RCD-Beschaltung (parasitäre Induktivitäten und Zuleitungsinduktivitäten) werden hohe und steile Spannungsspitzen hervorgerufen. Die Bauteile der RCD-Beschaltung müssen daher so ausgewählt und aufgebaut werden, daß die erste Spannungsspitze 1 einen durch die Struktur der GTO-Tyristors vorgegebenen Wert nicht überschreitet. Eine hohe Spannung bei noch fließendem großen Anodenstrom hat neben einer hohen thermischen Belastung nämlich eine hohe Feldspitze in der p-Basiszone zur Folge, die zum lokalen Durchbruch des pn-Übergangs der Basiszonen und damit im allgemeinen zum Zerstören des GTO-Tyristors führt.

Nach Ablauf der Speicherphase $t_S$ (vgl. FIG 2) werden von der $n^+$-Emitterzone keine Elektronen mehr emittiert und der im Halbleiterkörper fließende Strom fließt als reiner Löcherstrom von der n-Basiszone über die p-Basiszone zur Gateelektrode. Die Raumladung dieser Defektelektronen addiert sich zur Raumladung, die durch die Dotierung der n-Basiszone und p-Basiszone gegeben ist. Damit ergibt sich eine Verschiebung der Feldspitze vom dotierten pn-Übergang in die p-Basiszone hinein, an dem die Dotierstoffkonzentration $N_2$ der p-Basiszone genau der Löcherdichte des fließenden Löcherstromes entspricht. Außerdem wird die Weite der Raumladungszone in der n-Basiszone gemäß $dE/dx = K \times (N_1 + /p/)$ in der n-

Basiszone, mit $N_1$ = Dotierstoffkonzentration der n-Basiszone und $p$ = Löcherdichte, reduziert. Die Raumladungszone in der p-Basiszone weitet sich dagegen gemäß $-dE/dx = (N_2 - p) \times K$ auf. K ist hier ein konstanter Faktor.

In FIG 3 ist das Dotierungsprofil eines erfindungsgemäßen GTO-Tyristors dargestellt. Dieses Dotierungsprofil unterscheidet sich vom Dotierungsprofil eines bekannten GTO-Tyristors, wie er in der FIG 1 dargestellt ist, in der Dotierung der p-Basiszone. Die p-Basiszone weist einen vom pn-Übergang der Basiszonen aus gesehen mindestens 20 µm, vorteilhafterweise einen größer als 30 µm breiten Bereich auf, in dem ein maximaler Dotierungsgradient $dN_2/dx = 5 \times 10^{16}$ cm$^{-4}$ nicht überschritten ist. Dieser Bereich weist eine Grunddotierstoffkonzentration von $N_2 = j/(e \times v)$ auf. Dabei bedeutet j = maximale Stromdichte im Abschaltfall bei homogen angenommener Verteilung des Stromes, e (Elementarladung) = $1,6 \times 10^{-19}$ As und v (Sättigungsgeschwindigkeit der Ladungsträger im Halbleiterkörper) = $10^7$ cm/sec. Dadurch, daß der Bereich mindestens 20 µm breit ist, ist sowohl eine gute dynamische Spannungsfestigkeit als auch eine gute Zündeigenschaft des Thyrisors gewährleistet.

Die absolute Höhe der Dotierung in der p-Basiszone nahe dem im Abschaltfall sperrenden pn-Übergang ist damit so gewählt, daß der Kompensationspunkt $N_2 = p$ bei nomogen angenommener Stromdichte des abzuschaltenden Stromes nahe am pn-Übergang liegt.

Ein Beispiel soll das Dotierungsprofil in diesem Bereich verdeutlichen:

Die wirksame Fläche des Halbleiterkörpers im Abschaltfall sei 25 cm². Es soll ein Strom von 2200 A abgeschaltet werden. Dadurch ergibt sich eine Stromdichte j = 88 A/cm² bei homogen angenommener Verteilung des Stromes. Für die Löcherdichte p ergibt sich gemäß $p = j/(e \times v)$ ein Wert von $5,5 \times 10^{13}$ cm$^{-3}$. Entspricht die Dotierstoffkonzentration $N_2$ in der p-Basiszone in einem mindestens 20 µm breiten Bereich genau diesem Wert, so kompensiert sich die Raumladung der Dotierung mit der Raumladung der fließenden Löcher in diesem Bereich, das heißt, die Raumladung hat in diesem Bereich den Wert O. Damit ist eine mindestens 20 µm ausgedehnte Zone hoher Feldstärke erreicht und somit eine hohe dynamische Spannungsfestigkeit gewährleistet.

Da die lokale Stromdichte j aufgrund von Inhomogenitäten der Dotierung im Halbleiterkörper nicht exakt bekannt ist und die lokale Stromdichte j außerdem zeitabhängig ist, ist in diesem Bereich ein maximal zulässiger Dotierungsgradient $dN_2/dx = 5 \times 10^{16}$ cm$^{-4}$ vorgesehen, das heißt, daß im Abstand von 20 µm vom pn-Übergang der Basiszonen eine maximale Dotierstoffkonzentration von

$10^{14}$ cm$^{-3}$ über der der Grunddotierstoffkonzentration $N_A$ vorhanden sein darf.

In der Darstellung nach FIG 3 schließt an den mindestens 20 µm breiten Bereich ein hochdotierter p-Basisbereich an. Dadurch ist unter der n-Emitterzone eine gute Querleitfähigkeit gewährleistet.

In FIG 4 ist ein weiteres Beispiel eines Dotierungsprofiles für einen GTO-Tyristor dargestellt. Der Unterschied zum Dotierungsprofil, wie es in FIG 4 gezeigt ist, liegt darin, daß an den mindestens 20 µm breiten Bereich ein hochdotierter p-Bereich zur Erhaltung der Querleitfähigkeit angeordnet ist und zwischen diesen hochdotierten p-Bereich und der sehr hoch dotierten n-Emitterzone ein weiterer p-dotierter Basisbereich angeordnet ist. Die Dotierstoffkonzentration dieses p-Basisbereiches ist niedriger als die Dotierstoffkonzentration im erwähnten hochdotierten Basisbereich, jedoch höher als die im mindestens 20 µm breiten p-Basisbereich. Dies hat den Vorteil, daß die Durchbruchspannung zwischen n-Emitterzone und p-Basiszone von der Eindringtiefe der n-Emitterzone und von der Wahl der Querleitfähigkeit der p-Basiszone weitgehend unabhängig ist.

Der mindestens 20 µm breite Bereich ist entweder epitaktisch auf die p-Basiszone aufgebracht oder durch Diffusion in den Halbleiterkörper eingebracht. Zur Diffusion ist es zweckmäßig eine Diffusion eines schnell diffundierenden Stoffes, z.B. Aluminium vorzusehen. Der hochdotierte p-Basisbereich ist durch Diffusion eines langsam diffundierenden Stoffes, z. B. Gallium, oder Bor, in den Halbleiterkörper eingebracht oder durch Epitaxie auf den p-Basisbereich, der den maximal zulässigen Dotierungsgradienten aufweist, aufgebracht.

Gemäß der Erfindung ist es nicht nur möglich die dynamische Spannungsfestigkeit von GTO-Tyristoren zu erhöhen. Vielmehr kann gemäß der Erfindung jedes Leistungshalbleiterbauelement mit einem pn-Übergang, der beim Stromkommutieren schnell ausgeräumt werden muß, wie z. B. bei Dioden oder bei Bipolartransistoren, die durch Inversion der Basisansteuerung abgeschaltet werden oder Thyristoren mit Abschalthilfe in ihrer dynamischen Spannungsfestigkeit verbessert werden.

Dies gelingt, sofern der im Abschaltfall sperrende pn-Übergang bzw. die den pn-Übergang bildenden Zonen unterschiedlichen Leitfähigkeitstyps gemäß der Erfindung ausgebildet sind.

## Ansprüche

1. Abschaltbares Leistungshalbleiterbauelement mit einem Halbleiterkörper, der mindestens zwei aneinandergrenzende Zonen entgegengesetzten Leitfähigkeitstyps aufweist, welche im Abschaltfall einen sperrenden pn-Übergang bilden, und dessen eine Zone eine konstante Dotierstoffkonzentration $(N_1)$ aufweist,

**dadurch gekennzeichnet,**

daß die andere Zone einen an den pn-Übergang anschließenden mindestens $20.10^{-5}$ m breiten Bereich aufweist,

daß dieser Bereich eine Grunddotierstoffkonzentration $N_2 = j/(e \cdot v)$ mit $j$ = maximale Stromdichte im Abschaltfall bei homogen angenommener Verteilung, $e$ = Elementarladung und $v = 10^7$ cm·sec. aufweist, und daß in diesem Bereich ein von pn-Übergang aus gesehen maximaler Dotierungsgradient $dN_2/dx = 5 \cdot 10^{15}$ cm$^{-4}$ nicht überschritten ist.

2. Abschaltbares Leistungshalbleiterbauelement nach Anspruch 1, **dadurch gekennzeichnet,** daß der Bereich breiter als 30 µm ist.

3. Abschaltbares Leistungshalbleiterbauelement nach Anspruch 1 oder 2,

**dadurch gekennzeichnet,**

daß der Bereich auf die andere Zone epitaktisch aufgebracht ist.

4. Abschaltbares Leistungshalbleiterbauelement nach Anspruch 1 oder 2,

**dadurch gekennzeichnet,**

daß der Bereich ein durch Diffusion in den Halbleiterkörper eingebrachter Bereich ist.

5. Abschaltbares Leistungshalbleiterbauelement nach einem der Ansprüche 1 bis 4,

**dadurch gekennzeichnet,**

daß an den Bereich eine höher dotierte Schicht gleichen Leitfähigkeitstyps grenzt.

6. Abschaltbares Leistungshalbleiterbauelement nach Anspruch 5,

**dadurch gekennzeichnet,**

daß an die höher dotierte Schicht eine Schicht niedriger Dotierung grenzt, deren Dotierstoffkonzentration jedoch größer als die Dotierstoffkonzentration des Bereiches ist.

7. Abschaltbares Leistungshalbleiterbauelement nach einem der Ansprüche 1 bis 6,

**dadurch gekennzeichnet,**

daß der Halbleiterkörper einen Thyristor bildet.

8. Abschaltbares Leistungshalbleiterbauelement nach einem der Ansprüche 1 bis 6,

**dadurch gekennzeichnet,**

daß der Halbleiterkörper eine Diode bildet.

9. Abschaltbares Leistungshalbleiterbauelement nach einem der Ansprüche 1 bis 6,

**dadurch gekennzeichnet,**

daß der Halbleiterkörper einen Bipolartransistor bildet.

0 283 788

FIG 1

FIG 2

FIG 3

FIG 4

Europäisches
Patentamt

**EUROPÄISCHER RECHERCHENBERICHT**

Nummer der Anmeldung

EP 88 10 3311

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-A-2 507 104 (BROWN & BOVERI) <br> * Figur 3; Seite 9, Zeilen 20-24 * <br> --- | 1-3 | H 01 L 29/36 <br> H 01 L 29/74 <br> H 01 L 29/10 |
| X | PATENT ABSTRACTS OF JAPAN, Band 5, Nr. 145 (E-74)[817], 12. September 1981, Seite 146 E 74; & JP-A-56 80 163 (MITSUBISHI DENKI K.K.) 01-07-1981 <br> * Die ganze Zusammenfassung * <br> --- | 1 | |
| A | DE-A-2 802 727 (HITACHI) <br> ----- | | |

| | |
|---|---|
| | **RECHERCHIERTE SACHGEBIETE (Int. Cl.4)** |
| | H 01 L 29 |

Der vorliegende Recherchenbericht wurde für alle Patentansprüche erstellt

| Recherchenort | Abschlußdatum der Recherche | Prüfer |
|---|---|---|
| DEN HAAG | 23-06-1988 | PELSERS L. |